# EUROPEAN PATENT SPECIFICATION

(11) **EP 0 908 312 B1**
(45) Date of publication and mention of the grant of the patent: **10.04.2002**
(21) Application number: 97922191.8
(22) Date of filing: 26.05.1997
(51) Int. Cl.: B41F 15/42, H05K 3/12

(54) **SCREEN PRINTING METHOD AND SCREEN PRINTING PRESS**
SIEBDRUCKVERFAHREN UND SIEBDRUCKMASCHINE
PROCEDE ET PRESSE D'IMPRESSION AU CADRE

(30) Priority: 30.05.1996 JP 13603096
(43) Date of publication of application: 14.04.1999
(73) Proprietor: MATSUSHITA ELECTRIC INDUSTRIAL CO., LTD., Kadoma-shi, Osaka 571-0050 (JP)
(72) Inventor: NISHIOKA, Shinichi, Kofu-shi, Yamanashi 400 (JP); TAKAHASHI, Ken, Nakakoma-gun, Yamanashi 409-38 (JP); NAITO, Takao, Nakakoma-gun, Yamanashi 409-38 (JP); MASUI, Masuo, Nakakoma-gun, Yamanashi 400-01 (JP)
(74) Representative: Grünecker, August, Dipl.-Ing.
(86) International application number: JP9701783
(87) International publication number: WO9745265

(56) References cited:
- JP-A- 3 275 357

## Description

### Technical Field

The present invention mainly relates to a screen printing method and apparatus for printing on sheets or on a circuit board such as a printed circuit board on which an electronic circuit is formed, printing past such as cream solder and past used to form a thick-film circuit.

### Background Art

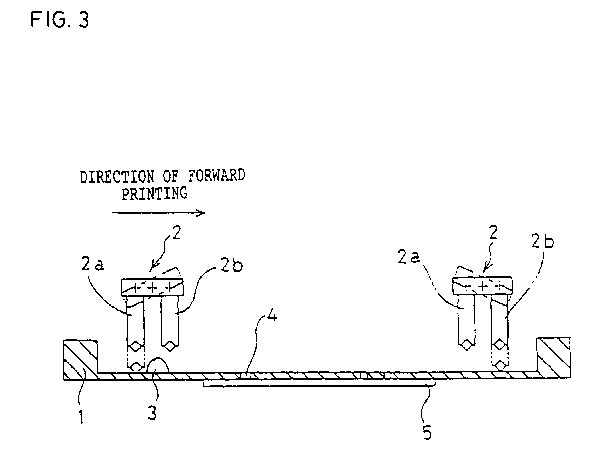

JPA 7-89208 discloses the use of reciprocal printing as a screen printing method in an initial period in which a cleaned or a new screen is used. FIG. 3 shows this printing method.

In the following description, printing from left to right is called forward printing, while printing from right to left is called return printing. The forward and return paths, however, are not limited to the left to right and right to left directions, respectively.

Reference numeral 1 designates a screen, and a squeegee 2 is composed of a pair of a forward squeegee 2a and a return squeegee 2b. An amount of cream solder 3 is supplied that can be filled between the squeegees 2a and 2b. Reference numeral 4 denotes a screen opening, and 5 is a circuit board subjected to printing.

The printing operation is described below that is performed in the initial period in which a cleaned screen 1 or a new screen is used.

First, the forward squeegee 2a lowers onto the screen 1, moves the cream solder 3 rightward while pressing it against the screen 1 using its tip, and stops after reaching a predetermined position.

Next, the forward squeegee 2a elevates, and the return squeegee 2b lowers onto the screen 1 to switch the printing direction. The return squeegee 2b moves the cream solder 3 leftward while pressing it against the screen 1 using its tip, and stops after reaching a predetermined position. The reciprocal printing is completed in this manner, followed by snapping-off.

The structure has been proposed in which a pair of squeegees 2a and 2b constitute a link structure and vertically seesaw to switch the squeegees as shown in FIG. 3.

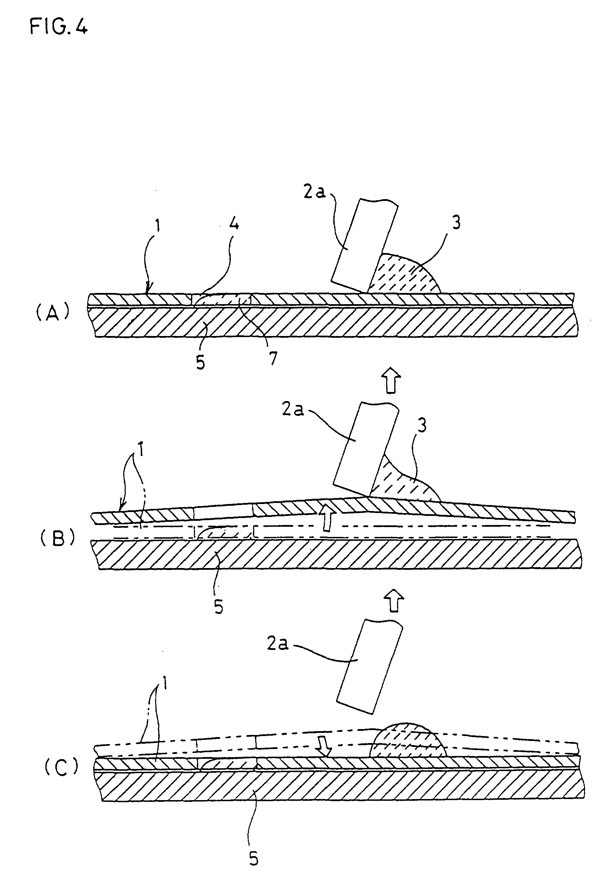

In the reciprocal printing, when the printing direction is switched, the squeegee that has finished printing is elevated and the return squeegee is lowered onto the screen 1. As shown in FIG. 4(A), when the forward squeegee 2a is elevated after forward printing, the screen 1 is lifted as shown in FIG. 4(B) because the screen 1 is stuck to the squeegee 2a due to the viscosity of the cream solder 3.

When the cream solder 3 is separated from the squeegee 2a, the screen 1 attempts to return to its original position and behaves as if it is snapped, as shown in FIG. 4(C).

Thus, the screen 1 with the printed cream solder 7 collides against the circuit board 5, resulting in nonuniform printing to affect the quality.

A printer using a forward and a reverse squeegee is disclosed in the document JP 3 275 357.

### Disclosure of the Invention

This invention solves this conventional problem and has an object to provide a screen printing method and an apparatus that restrain a screen from behaving as if it is snapped when squeegees are switched, thereby avoiding nonuniformity of reciprocal printing to improve the quality.

The screen printing method set forth in claim 1 of this invention is characterized in that when reciprocating a forward and a return squeegee on a screen horizontaly laying over a sheet in the printing position and having an opening in a predetermined pattern, the method comprises: the steps of lowering a return squeegee onto a screen from its standby position to abut the screen, while a forward squeegee which has finished its forward printing is abutting the screen; elevating the forward squeegee from the screen after the return squeegee has abutted the screen, thereby preventing the screen from being lifted and returning to its original position which is the printing position as if it is snapped when the forward squeegee is elevated in order for switching the squeegees; and then performing return printing using the return squeegee. The forward squeegee is elevated from the screen while the screen is pressed by the return squeegee. Thereby, the screen is prevented from being lifted and returning to its original position as if it is snapped when the forward squeegee is elevated in order for switching the squeegees. As a result, the quality of printed shapes is improved.

The screen printing method set forth in claim 2 of this invention is characterized in that during normal production, printing is executed by moving either the forward or the return squeegee in only one direction and in that after the end of a step of cleaning the rear surface of the screen or at the start of production after the replacement of the screen due to a change in machine type, printing is executed by reciprocating the squeegees until an arbitrarily-set number of sheets have been printed. The arbitrarily-set number of sheets can be set to such number as being capable of undergoing effective printing by the reciprocal printing which is performed after the end of the step of cleaning the rear surface of the screen or the start of production after the replacement of the screen due to a change in machine type until the quality of printed shapes gets stabilized.

The screen printing apparatus set forth in claim 3 of this invention is characterized in that when reciprocating a forward and a return squeegee on a screen horizontaly laying over a sheet in the printing position and having an opening in a predetermined pattern, a means for switching printing from forward direction to return direction lowers the return squeegee on the screen before the forward squeegee elevates to its standby position located above the screen, so that the screen can be prevented from being lifted and returning to its original position which is the printing position as if it is snapped when the forward squeegee is elevated in order for switching the squeegees. The operation for elevating the forward squeegee to its standby position located above the screen and lowering and abutting it on the screen and the operation for elevating the return squeegee to its standby position located above the screen and lowering and abutting it on the screen can be performed without affecting each other.

### Brief Description of the Drawings

FIG. 1 is an explanatory view of reciprocal printing according to the invention;
FIG. 2 (A), (B) and (C) each is an explanatory view of squeegee switching during the reciprocal printing according to the invention;
FIG. 3 is an explanatory view of conventional reciprocal printing; and
FIG. 4 (A), (B) and (C) each is an explanatory view showing the behavior of a screen during squeegee switching in the conventional reciprocal printing.

### Description of the Embodiments

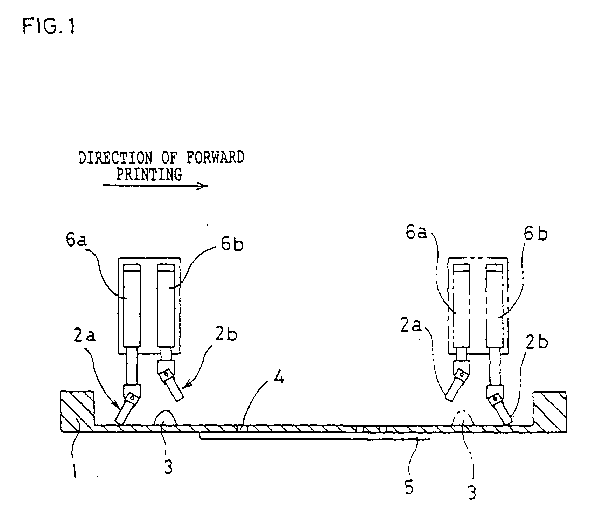

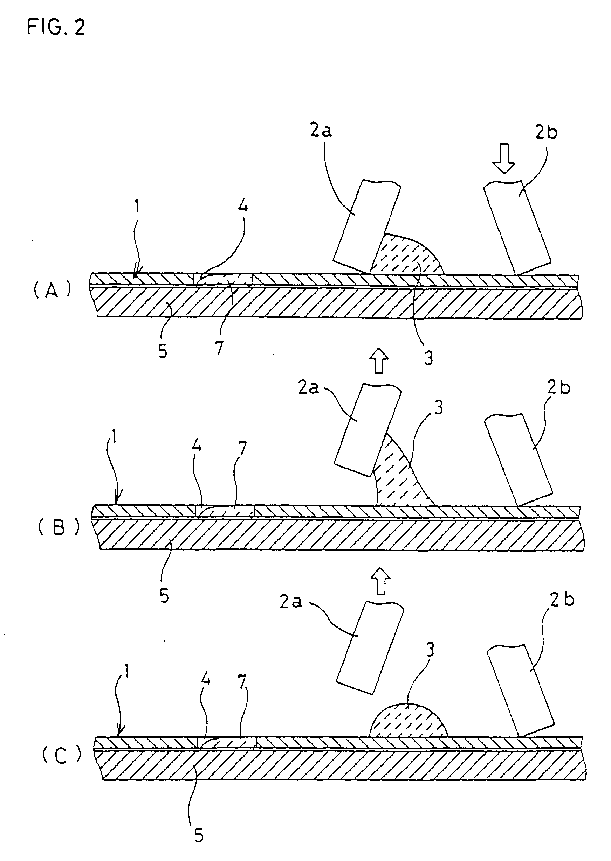

Embodiments of this invention are described below with reference to FIGS. 1 and 2. Those components that have the same functions as in the prior art have the same reference numerals.

In FIG. 1, 1 is a screen, and a squeegee 2 is composed of a pair of a forward squeegee 2a and a return squeegee 2b. An amount of cream solder 3 is supplied that can be filled between the squeegees 2a and 2b. Reference numeral 4 designates a screen opening, and 5 is a circuit board.

Reference numeral 6a is a forward-squeegee-elevating actuator, 6b is a return-squeegee-elevating actuator. The actuators 6a and 6b are configured so that they can be individually positioned and controlled.

After the end of a step of cleaning the rear surface of the screen or at the start of production after the replacement of the screen due to a change in machine type, an operation of printing the screen 1 is performed as follows until an arbitrarily-set number of sheets are printed.

During forward printing, the forward squeegee 2a lowers and abuts onto the screen 1, moves the cream solder 3 rightward while pressing it against the screen 1 using its tip, and then stops after reaching a predetermined position.

Next, the return squeegee 2b lowers and abuts on the screen 1 as shown in FIG. 2(A), and the forward squeegee 2a is then elevated as shown in FIG. 2(B) to switch the printing direction. FIG. 2(C) shows that the cream solder 3 has left the forward squeegee 2a.

After the squeegees have been switched, the return squeegee 2b moves the cream solder 3 leftward while pressing it against the screen 1 using its tip and stops after reaching a predetermined position. The reciprocal printing is completed in this manner, followed by snapping-off.

This operation enables the forward squeegee to be elevated after the return squeegee has abutted the screen. Thus, when the printing direction is switched, the screen is prevented from being lifted due to the adhesion of the cream solder 3 and from returning to its original position as if it is snapped. Therefore, the quality of printed shapes can be improved.

During normal production, printing can be performed by moving either the forward or return squeegee in only one direction. In this case, after the step of cleaning the rear surface of the screen or at the start of production after the replacement of the screen due to a change in machine type, the squeegees may be reciprocally moved to print an arbitrarily-set number of sheets. In this case, the arbitrarily-set number of sheets may be set to such number as being capable of undergoing effective printing by the reciprocal printing which is performed after the end of the step of cleaning the rear surface of the screen or the start of production after the replacement of the screen due to a change in machine type until the quality of printed shapes gets stabilized.

## Claims

1. A screen printing method for performing printing by reciprocating a forward (2a) and a return squeegee (2b) on a screen (1) horizontaly laying over a sheet in the printing position and having an opening (4) in a predetermined pattern, the method comprising the steps of:
lowering the return squeegee (2b) from its standby position so as to abut the screen (1) while the forward squeegee (2a) which has finished its forward printing is abutting onto the screen (1);
elevating the forward squeegee (2a) from the screen (1) after the return squeegee (2b) has abutted the screen (1) thereby preventing the screen from being lifted and returning to its original position which is the printing position as if it is snapped when the forward squeege is elevated in order for switching the squeegees and performing return printing by using the return squeegee (2b).

2. A screen printing method according to claim 1 wherein during normal production, printing is performed by moving either the forward (2a) or the return squeegee (2b) in only one direction, and after the end of a step of cleaning the rear surface of the screen (1) or at the start of production after replacement of the screen (1) due to a change in machine type, printing is performed by reciprocating the squeegees until an arbitrarily-set number of sheets have been printed.

3. A screen printing apparatus for performing printing by reciprocating a forward (2a) and a return squeegee (2b) on a screen (1) horizontaly laying over a sheet in the printing position and having an opening (4) in a predetermined pattern, wherein a means for switching printing from forward direction to return direction lowers the return squeegee (2b) onto the screen (1) before the forward squeegee (2a) elevates to its standby position located above the screen (1), so that the screen (1) can be prevented from being lifted and returning to its original position which is the printing position as if it is snapped when the forward squeegee (2a) is elevated in order for switching the squeegees.

## Patentansprüche

1. Siebdruckverfahren zum Ausführen von Drucken durch das Hin- und Herbewegen einer Vorwärts-(2a) und einer Rückwärts-Rakel (2b) auf einem Sieb (1), das horizontal über einem Blatt in der Druckposition liegt und eine Öffnung (4) in einem vorgegebenen Muster aufweist, wobei das Verfahren die folgenden Schritte umfasst:
Absenken der Rückwärts-Rakel (2b) aus ihrer Bereitschaftsposition, so dass sie an dem Sieb (1) anliegt, während die Vorwärts-Rakel (2a), die ihr Vorwärts-Drucken abgeschlossen hat, an dem Sieb (1) anliegt;
Anheben der Vorwärts-Rakel (2a) von dem Sieb (1), nachdem die Rückwärts-Rakel (2b) an dem Sieb (1) anliegt, um so zu verhindern, dass das Sieb angehoben wird und in seine Ausgangsposition zurückkehrt, die die Druckposition ist, so als ob es geschnappt wäre, wenn die Vorwärts-Rakel angehoben wird, um die Rakeln zu wechseln und
Ausführen des Rückwärts-Druckens mit der Rückwärts-Rakel (2b).

2. Siebdruckverfahren nach Anspruch 1, wobei während der normalen Produktion das Drucken ausgeführt wird, indem entweder die Vorwärts-(2a) oder die Rückwärts-Rakel (2b) nur in einer Richtung bewegt wird, und nach dem Ende des Schritts des Reinigens der Rückseite des Siebs (1) oder beim Beginn der Produktion nach dem Austauschen des Siebs (1) aufgrund einer Veränderung des Maschinentyps, das Drucken ausgeführt wird, indem die Rakeln hin- und herbewegt werden, bis eine beliebig festgelegte Anzahl von Blättern bedruckt worden ist.

3. Siebdruckvorrichtung zum Ausführen von Drucken durch das Hin- und Herbewegen einer Vorwärts-(2a) und einer Rückwärts-Rakel (2b) auf einem Sieb (1), das horizontal über einem Blatt in der Druckposition liegt und eine Öffnung (4) in einem vorgegebenen Muster aufweist, wobei eine Einrichtung zum Wechseln vom Drucken in Vorwärts-Richtung zum Drucken in Rückwärts-Richtung die Rückwärts-Rakel (2b) auf das Sieb (1) absenkt, bevor die Vorwärts-Rakel (2a) sich zu ihrer Bereitschaftsposition anhebt, die sich über dem Sieb (1) befindet, so dass verhindert werden kann, dass das Sieb (1) angehoben wird und in seine Ausgangsposition zurückkehrt, die die Druckposition ist, so als ob es geschnappt wäre, wenn die Vorwärts-Rakel (2a) angehoben wird, um die Rakeln zu wechseln.

## Revendications

1. Procédé de sérigraphie destiné à effectuer une impression en animant d'un mouvement de va-et-vient une racle avant (2a) et une racle de retour (2b) sur un écran (1) reposant horizontalement sur une feuille en position d'impression et présentant une ouverture (4) selon un motif prédéterminé, le procédé comprenant les étapes consistant à :
abaisser la racle de retour (2b) à partir de sa position d'attente de façon à buter contre l'écran (1) pendant que la racle avant (2a) qui a fini son impression en avant bute contre l'écran (1) ;
élever la racle avant (2a) de l'écran (1) après que la racle de retour (2b) a buté contre l'écran (1), ce qui a pour effet d'éviter que l'écran soit soulevé et ramené à sa position d'origine qui est la position d'impression comme s'il était accroché lorsque la racle avant est élevée afin d'effectuer l'inversion des racles, et
effectuer l'impression de retour en utilisant la racle de retour (2b).

2. Procédé de sérigraphie selon la revendication 1, dans lequel pendant la production normale on effectue l'impression en déplaçant soit la racle avant (2a) soit la racle de retour (2b) dans une seule direction et après la fin d'une étape de nettoyage de la surface arrière de l'écran (1) ou au démarrage de la production après remplacement de l'écran (1) en raison d'un changement du type de machine, on effectue l'impression en animant les racles d'un mouvement de va-et-vient jusqu'à l'impression d'un nombre de feuilles établi arbitrairement.

3. Appareil de sérigraphie destiné à effectuer une impression en animant d'un mouvement de va-et-vient une racle avant (2a) et une racle de retour (2b) sur un écran (1) reposant horizontalement sur une feuille en position d'impression et présentant une ouverture (4) selon un motif prédéterminé, dans lequel un moyen destiné à inverser une impression depuis une direction vers l'avant pour une direction de retour abaisse la racle de retour (2b) sur l'écran (1) avant que la racle avant (2a) ne s'élève jusqu'à sa position d'attente située au-dessus de l'écran (1) de façon à éviter que l'écran soit soulevé et ramené à sa position d'origine qui est la position d'impression comme s'il était accroché lorsque la racle avant (2a) est élevée afin d'effectuer l'inversion des racles.
